# EUROPEAN PATENT APPLICATION

(11) **EP 4 841 279 A1**
(43) Date of publication of application: **18.11.2026**
(21) Application number: 24917103.4
(22) Date of filing: 13.09.2024
(51) Int. Cl.: G01R 31/378, G01R 31/385, G01R 31/392, H01M 10/48

(54) **SECONDARY BATTERY STATE DETERMINATION DEVICE AND SECONDARY BATTERY DIAGNOSIS METHOD**

(30) Priority: 11.01.2024 JP 2024002508
(71) Applicant: Hitachi, Ltd., Tokyo 100-8280 (JP)
(72) Inventor: UEDA Suguru, Tokyo 100-8280 (JP)
(74) Representative: MERH-IP Matias Erny Reichl Hoffmann Patentanwälte PartG mbB
(86) International application number: PCT/JP2024/032978
(87) International publication number: WO 2025/150228

(57) **Abstract**

Provided is a secondary battery state determination device capable of determining an internal state of a secondary battery from a single measurement of the battery. The secondary battery state determination device includes a database containing records of relaxation spectra measured for a plurality of secondary batteries, and names of active materials for positive electrodes and negative electrodes, which are used for electrodes of the plurality of secondary batteries, a measurement unit for measuring time-series data of a secondary battery to be diagnosed, a calculation unit for calculating, from the time-series data measured by the measurement unit, a relaxation spectrum of the secondary battery to be diagnosed, a comparison unit for acquiring from the database a relaxation spectrum of a secondary battery, which matches a name of an active material used in the secondary battery to be diagnosed, and comparing the acquired relaxation spectrum with the relaxation spectrum calculated by the calculation unit, and a determination unit for determining, on a basis of a comparison result in the comparison unit, presence or absence of occurrence of an abnormality in the secondary battery to be diagnosed.

## Description

### Technical Field

The present invention relates to a configuration of a secondary battery state determination device and a secondary battery diagnosis method using the same, and more particularly to a technology that is effective when applied to evaluation of a remaining value of a secondary battery.

### Background Art

Lithium-ion secondary batteries (hereinafter, referred to as secondary batteries) are expected to be applied to and are being used in a wide range of products, from electric mobility applications such as electric vehicles to stationary power sources, and demand for the secondary batteries is steadily expanding. Generally, the life of a secondary battery is known to be closely related to usage conditions of the secondary battery, and if the secondary battery is used continuously under high-load conditions, battery performance will rapidly be degraded (hereinafter, referred to as an abnormal degradation). Therefore, in order to use the secondary battery stably until the end of its product life, it is important to properly determine the degradation state of the secondary battery.

Furthermore, in recent years, there have been attempts to reuse, as stationary power sources, used batteries that have reached the end of their life in electric vehicles. From the perspective of product reliability and safety, there has been a need for methods for determining the degradation state of the used batteries and the presence or absence of the abnormal degradation in the used batteries at the time of the reuse.

Examples of battery abnormalities include current concentration and lithium deposition. The former, current concentration, is degradation that occurs when a secondary battery is used with a high current, and is a phenomenon in which the high current flows locally within the battery, causing a rapid degradation in that portion. Further, the latter, lithium deposition, is a degradation phenomenon that occurs when a secondary battery is used at low temperatures and high voltages, and is a phenomenon in which lithium ions are deposited on a negative electrode during a charging and discharging process, causing a degradation in capacity and resistance of the secondary battery. Furthermore, it has been also reported that if the lithium deposition phenomenon continues to progress, it could eventually lead to an internal short circuit in the secondary battery.

Therefore, studies are underway to analyze an internal state of batteries in order to detect battery abnormalities within the batteries. For example, the abstract of PTL 1 describes that "An analytical device is provided. The analytical device includes a battery condition analysis section configured to detect a state change of a constituent member of a battery based on a change in peak of a relaxation time in a predetermined frequency band." Citation List

### Patent Literature

Patent Literature 1: International Publication No. WO 2017/179266

### Summary of Invention

### Technical Problem

In order to implement the method of PTL 1 described above, it is necessary to compare a peak change of the relaxation time in the predetermined frequency band before the capacity and resistance of a secondary battery is degraded (pre-degradation stage) and after the capacity and resistance of the secondary battery is degraded (degradation stage). Therefore, the method of PTL 1 requires at least two measurements at the pre-degradation stage and degradation stage.

Generally, since measurement of a battery condition requires a certain amount of measurement time and effort, it is preferable to minimize the number of measurements. Furthermore, since the method of PTL 1 requires the measurement of the secondary battery at the pre-degradation stage, it cannot be applied to any application other than an application in which the battery is used continuously from the pre-degradation stage to the degradation stage. For example, in the case of used batteries, the method of PTL 1 cannot be applied since secondary battery characteristics at the pre-degradation stage cannot be acquired even by measuring the used batteries.

Therefore, the object of the present invention is to provide a secondary battery state determination device and a secondary battery diagnosis method that are capable of determining an internal state of a secondary battery from a single measurement of the battery.

### Solution to Problem

In order to solve the above problem, the present invention includes a database containing records of relaxation spectra measured for a plurality of secondary batteries, and names of active materials for positive electrodes and negative electrodes, which are used for electrodes of the plurality of secondary batteries, a measurement unit for measuring time-series data of a secondary battery to be diagnosed, a calculation unit for calculating, from the time-series data measured by the measurement unit, a relaxation spectrum of the secondary battery to be diagnosed, a comparison unit for acquiring from the database a relaxation spectrum of a secondary battery, which matches a name of an active material used in the secondary battery to be diagnosed, and comparing the acquired relaxation spectrum with the relaxation spectrum calculated by the calculation unit, and a determination unit for determining, on a basis of a comparison result in the comparison unit, presence or absence of occurrence of an abnormality in the secondary battery to be diagnosed.

Furthermore, the present invention relates to a secondary battery diagnosis method including (a) a step of measuring time-series data of a secondary battery to be diagnosed, (b) a step of calculating, from the time-series data measured in the step (a), a relaxation spectrum of the secondary battery to be diagnosed, (c) a step of acquiring from a database a relaxation spectrum of a secondary battery, which matches a name of an active material used in the secondary battery to be diagnosed, (d) a step of comparing the relaxation spectrum acquired in the step (c) with the relaxation spectrum calculated in the step (b), and (e) a step of determining, on a basis of a comparison result in the step (d), presence or absence of occurrence of an abnormality in the secondary battery to be diagnosed. Advantageous Effects of Invention

According to the present invention, it is possible to realize a secondary battery state determination device and a secondary battery diagnosis method that are capable of determining an internal state of a secondary battery from a single measurement of the battery.

This will enable a proper evaluation of a remaining value of the secondary battery.

Objects, configurations, and effects other than the above will be apparent from the description of the following embodiments.

### Brief Description of Drawings

Fig. 1 is a diagram illustrating a schematic configuration of a secondary battery state determination device according to a first embodiment of the present invention.
Fig. 2 is a diagram schematically illustrating an example of a peak position of a relaxation spectrum.
Fig. 3A is a diagram illustrating an example of a comparison result of relaxation spectra. (before the application of Equation (3)).
Fig. 3B is a diagram illustrating an example of a comparison result of the relaxation spectra according to the present invention (after the application of Equation (3)).
Fig. 4 is a diagram illustrating an example of a comparison result of the relaxation spectra according to the first embodiment of the present invention.
Fig. 5 is a diagram illustrating an example of a comparison result of the relaxation spectra according to a second embodiment of the present invention.
Fig. 6A is a diagram illustrating an example of a comparison result of the relaxation spectra according to a third embodiment of the present invention. (battery abnormality is present).
Fig. 6B is a diagram illustrating an example of a comparison result of the relaxation spectra according to the third embodiment of the present invention. (battery abnormality is absent).
Fig. 7 is a flowchart illustrating a secondary battery diagnosis method according to the first embodiment of the present invention.

### Description of Embodiments

Embodiments of the present invention will be described below with reference to the drawings. Note that components with the same configuration or similar functions are denoted by the same reference sign in each drawing, and detailed descriptions of overlapping parts are omitted.

Furthermore, in the following, a spectrum in a biaxial coordinate system, in which one axis represents a relaxation time and the other axis represents a spectral intensity, will be referred to as a relaxation spectrum or a relaxation time distribution.

### First Embodiment

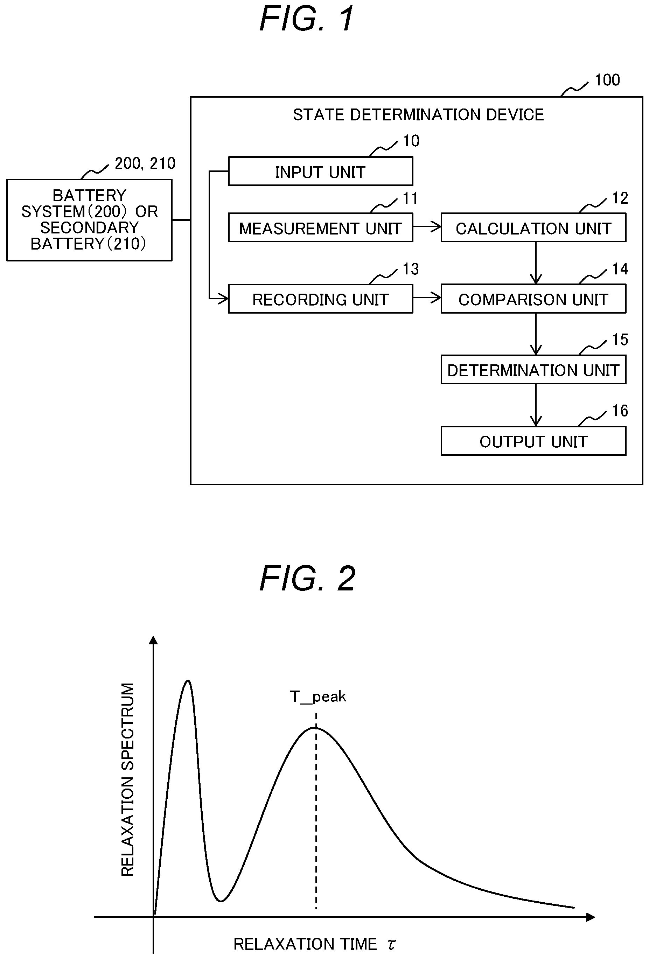

A secondary battery state determination device and a secondary battery diagnosis method according to the first embodiment of the present invention will be described with reference to Figs. 1 to 4 and Fig. 7.

Fig. 1 is a block diagram illustrating a secondary battery state determination device 100 of the present embodiment. As illustrated in Fig. 1, the secondary battery state determination device 100 of the present embodiment uses measurement data for a battery system 200 or a secondary battery 210.

Here, the battery system 200 is a system including at least one secondary battery 210 and a control device therefor (not illustrated). In the following, the embodiment will be described assuming that the state determination device 100 is connected to the secondary battery 210. However, the method of the present invention is not limited to the following embodiment, but can be freely modified within a range that does not significantly impair the effects of the present invention.

The secondary battery state determination device 100 includes, as main components thereof, an input unit 10, a measurement unit 11, a calculation unit 12, a recording unit 13, a comparison unit 14, a determination unit 15, and an output unit 16. These may all be configured as a single unit, or at least some of them may be configured as separate units.

The input unit 10 takes, as an input, a material name of an active material used in a positive electrode and a negative electrode of the secondary battery 210. The "active material" refers to one of materials that make up the electrodes of the secondary battery. The active material plays a role in facilitating a charge-discharge reaction of the secondary battery by storing and releasing lithium ions during charging and discharging. Typical active materials include graphite, lithium manganese oxide, Li (NiMnCo)O₂, and the like. There are no particular restrictions on the input method to the input unit 10, as long as the method is an input method that can identify the active material used in the secondary battery 210.

For example, a substance name, an empirical formula, or the like may be input, a commonly used abbreviation for proper nouns (for example, "NMC" for Li(NiMnCo)O₂) may be input, or even a data sequence used in machine learning, such as a descriptor, may be input.

The measurement unit 11 is configured to measure time-series data of respective value including a DC current value and a value of at least either a DC voltage value or state of charge (SOC) of the secondary battery 210 during charging or discharging that is at least either during charging or during discharging of the secondary battery 210. That is, the time-series data includes the time-series data of the DC current value and the time-series data of the value of at least either the DC voltage value or the SOC of the secondary battery 210. The measurements are performed continuously or at predetermined time intervals (for example, every minute) during charging or discharging of the secondary battery 210 and during use including, for example, during standby when no charging or discharging is performed.

Since there is a correlation between the DC voltage value and the SOC, in the following example, the measurement unit 11 measures the time-series data related to the DC voltage value. However, the measurement unit 11 may measure the time-series data of the SOC. Furthermore, in the present embodiment, the time-series data may further include time-series data of the temperature of the secondary battery 210.

The measurement unit 11 extracts, from a collection of the measured time-series data (so-called "raw data"), time-series data during a period (timing) in which a relaxation spectrum can be calculated. The relaxation spectrum is a continuous function of a relaxation time, and is a relaxation spectrum (relaxation time distribution) in a biaxial coordinate system where one axis (for example, the horizontal axis) represents the relaxation time and the other axis (for example, the vertical axis) represents a spectral intensity.

In order to calculate the relaxation spectrum, it is preferable to use each time-series data in at least any one of periods which are during constant voltage charging, after charging, or after discharging, for example. After charging may be after constant voltage charging or after constant current charging. After discharging may be after constant voltage discharging or after constant current discharging.

In a case where the time-series data during constant voltage charging is extracted, the measurement unit 11 extracts respective pieces of time-series data of the voltage value, the current value, and the temperature of the secondary battery 210 from time t1 at which constant voltage charging starts to time t2 at which constant voltage charging ends. "Constant voltage charging" is a charging method in which the secondary battery 210 is charged while being maintained at a constant voltage value. Furthermore, the measurement unit 11 also extracts the voltage value before (preferably immediately before) the start of charging the secondary battery 210. There is no restriction on a duration from the time t1 to the time t2, but the duration is preferably 1 minute or more and 120 minutes or less, and more preferably 10 minutes or more and 60 minutes or less.

In a case where time-series data after charging (after the end of charging) or after discharging (after the end of discharging) is extracted, the measurement unit 11 extracts respective pieces of time-series data of the voltage value, the current value, and the temperature of the secondary battery 210 from end time t3 of charging or discharging to predetermined time t4. Furthermore, the measurement unit 11 also acquires the current value immediately before the charging or the discharging of the secondary battery 210 ends. There is no restriction on a duration from the time t3 to the time t4, but the duration is preferably 1 minute or more and 120 minutes or less, and more preferably 10 minutes or more and 60 minutes or less.

The calculation unit 12 calculates the relaxation spectrum from the time-series data in at least any one of the periods which are during constant voltage charging, after charging, or after discharging. By using these pieces of time-series data, it is possible to calculate the relaxation spectrum. A specific calculation method is as follows, but the calculation method is not limited to the following examples.

### <Calculation Method 1: a case where the relaxation spectrum is calculated from the measurement data during constant voltage charging>

In this case, a relaxation spectrum ρ(τ) can be calculated from Equation (1) by using the measurement data.$ρ \left(τ\right) = {L}^{- 1} \left(I\left(t\right)/ΔV\right)$ Equation (1) ρ(τ) represents the relaxation spectrum, ΔV represents a difference between the battery voltage value before (preferably immediately before) the start of charging and the voltage value during constant voltage charging, and I(t) represents time-series data of the current value during constant voltage charging. Furthermore, symbol L⁻¹ represents an inverse Laplace transform for I(t)/ΔV.

### <Calculation Method 2: a case where the relaxation spectrum is calculated from the measurement data after charging or after discharging>

In this case, a relaxation spectrum ρ(τ) can be calculated from Equation (2) by using the measurement data.$ρ \left(τ\right) = {L}^{- 1} \left(V\left(t\right)/{I}_{0}\right)$ Equation (2) ρ(τ) represents the relaxation spectrum, I₀ represents a current value immediately before the end of charging or immediately before the end of discharging, and V(t) represents time-series data of the voltage value after charging or after discharging. Furthermore, symbol L⁻¹ represents an inverse Laplace transform for V(t)/I₀.

A relaxation spectrum measured for the secondary battery 210, which is not experiencing any battery abnormality, and the name of the active material used in the secondary battery 210 are recorded in association with each other in the recording unit 13. Note that the secondary battery 210 the data of which is to be recorded in the recording unit 13 may be a different secondary battery from the secondary battery 210 included in the battery system 200.

Here, the "battery abnormality" refers to a degradation phenomenon such as current concentration or lithium deposition. Further, "the secondary battery, which is not experiencing any battery abnormality," refers to a secondary battery in a state (undegraded state) where, for example, battery performance such as capacity and resistance of the secondary battery is equal to or better than performance values specified in product specifications. Furthermore, "are recorded in association with each other" means being in a state where the relaxation spectrum of the secondary battery 210, which is recorded in the recording unit 13, can be acquired on the basis of the name of the active material used in the secondary battery 210.

It is preferable that relaxation spectra measured for a plurality of secondary batteries 210 and the names of active materials are recorded in the recording unit 13. Note that, in each of the plurality of secondary batteries 210, it is preferable that at least either an active material used in a positive electrode or an active material used in a negative electrode is different, and it is preferable that relaxation spectra of, for example, a secondary battery using graphite and lithium manganese oxide for a negative electrode and a positive electrode, respectively, and a secondary battery using graphite and Li(NiMnCo)O₂ (hereinafter, referred to as "NMC") for a negative electrode and a positive electrode, respectively, are recorded. Furthermore, it is particularly preferable that a relaxation spectrum of a secondary battery (half-cell), which uses lithium metal for either a positive electrode or a negative electrode, is recorded in the recording unit 13.

The comparison unit 14 compares shape information of the relaxation spectra between the calculation unit 12 and the recording unit 13 to determine the presence or absence of the battery abnormality. The following describes the procedure for comparing the relaxation spectra between the calculation unit 12 and the recording unit 13.

On the basis of the active material name of the secondary battery 210, which is acquired from the input unit 10, the comparison unit 14 searches the recording unit 13 for data of a secondary battery using the same active material and acquires a relaxation spectrum measured in that secondary battery. Here, if no data that perfectly matches the active material name of the secondary battery 210 is present on the recording unit 13, the following process is performed.
(1) A case where no data is present which matches a combination of the positive electrode and the negative electrode of the secondary battery 210
   In this case, a relaxation spectrum of a half-cell, which matches the active material name of the positive electrode of the secondary battery 210, and a relaxation spectrum of a half-cell, which matches the active material name of the negative electrode, are acquired from the recording unit 13. For example, when the secondary battery 210 is composed of graphite and lithium manganese oxide, the relaxation spectra of the half-cells for graphite and lithium manganese oxide, respectively, are acquired from the recording unit 13.
(2) A case where the positive electrode or the negative electrode, or both of the positive electrode and the negative electrode of the secondary battery 210 are composed of a plurality of active materials, and no data is present which corresponds to a combination thereof
   In this case, relaxation spectra of half-cells, which correspond to the respective active materials, are acquired from the recording unit 13. For example, when the negative electrode of the secondary battery 210 is composed of graphite and the positive electrode of the secondary battery 210 is composed of lithium manganese oxide and NMC, the relaxation spectra of the half-cells for graphite, lithium manganese oxide, and NMC are acquired from the recording unit 13.
(3) A case where the element mixing ratio of the active material used in the secondary battery 210 is different

In this case, a relaxation spectrum of a secondary battery with the different element mixing ratio is acquired from the recording unit 13. For example, when the active material of the positive electrode of the secondary battery 210 is NMC, and the element mixing ratio of N (nickel), M (manganese), and C (cobalt) is 8:1:1, a relaxation spectrum with the element mixing ratio of 1:1:1 may be acquired from the recording unit 13 to serve as a substitute for a relaxation spectrum when the element mixing ratio is 8:1:1.

Subsequently, the comparison unit 14 compares shape information between a relaxation spectrum A acquired from the recording unit 13 and a relaxation spectrum B of the secondary battery 210 obtained by the calculation unit 12. As the shape information, it is preferable to compare, for example, the number of peaks in the relaxation spectra, intensities of the respective peaks, positions of the respective peaks, areas of the respective peaks, full widths at half maximum of the respective peaks, and skewness of the respective peaks, and furthermore, the intensity ratios and area ratios of these. As a concrete example, it is effective to normalize the relaxation spectra A and B and the relaxation time by using the following Equation (3), and then compare differences in shape between the two on a graph.$J \left(τ*\right) = ρ \left(τ*\right) / \int dτ * ρ \left(τ*\right)$ Equation (3) Note that τ* = τ/τ_peak.

Here, ∫dτ* represents an integral with respect to a relaxation time τ*, where τ* means a relaxation time τ normalized by a peak position τ_peak having the largest area in the relaxation spectrum.

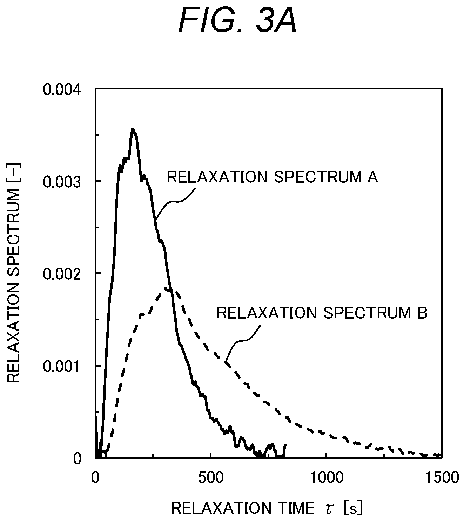

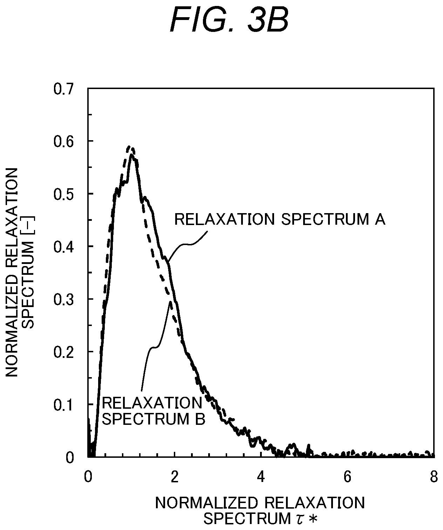

Fig. 2 schematically illustrates an example of the peak position (τ_peak) of the relaxation spectrum. Furthermore, Figs. 3A and 3B illustrate a state where the relaxation spectra A and B are applied with Equation (3) described above and are compared.

Fig. 3A illustrates the state before the application of Equation (3), and Fig. 3B illustrates the state after the application of Equation (3).

In a case where a plurality of relaxation spectra of a half-cell are acquired from the recording unit 13, the plurality of relaxation spectra are summed to obtain the relaxation spectrum A. As a method for summing the relaxation spectra of each half-cell, for example, a method for multiplying the relaxation spectra and the relaxation time by a constant and then summing them by using Equation (4) described below is effective. As an example, an example of a summation method in a case where relaxation spectra for half-cells of the positive electrode and the negative electrode are acquired from the recording unit 13 will be described. 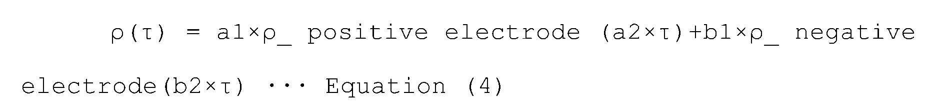 ρ(τ) = a1×ρ_ positive electrode (a2×τ)+b1×ρ_ negative electrode(b2×τ) ··· Equation (4)

Here, a1, a2, b1, and b2 are constants, and ρ_positive electrode (τ) and ρ_negative electrode (τ) represent relaxation spectra for half-cells of the positive electrode and the negative electrode, respectively.

ρ(τ) in Equation (4) described above is taken as the relaxation spectrum A and is compared with the relaxation spectrum B obtained by the calculation unit 12. At this time, the various constants in Equation (4) are determined such that X defined in the following Equation (5) is minimized.$X = \int dτ \left|ρ\left(τ\right)-ρ′\left(τ\right)\right|$ Equation (5)

Here, ρ' represents the relaxation spectrum B, and symbol |A| means that it is an absolute value of A. After each constant in the relaxation spectrum A is determined using the procedure described above, the comparison unit 14 compares the shape information between the relaxation spectra A and B.

The determination unit 15 determines, on the basis of the comparison result of the relaxation spectra in the comparison unit 14, the presence or absence of the battery abnormality in the secondary battery 210. The following describes a method for determining the battery abnormality.

Since the number of peaks in a relaxation spectrum corresponds to the number of reaction processes inside a battery, an increase in the number of peaks suggests that a transient reaction is occurring inside the battery. Therefore, if the number of peaks in the relaxation spectrum B is greater than that of the relaxation spectrum A, it is determined that the battery abnormality has occurred.

Even if the number of peaks in the relaxation spectrum increases, if peak positions are close together, it becomes difficult to accurately determine the number of peaks. However, since changes appear in the intensity, the area, the full width at half maximum, and the like of the peak, it is possible to determine that the battery abnormality has occurred if a difference in intensity, area, and full width at half maximum of the peak between the relaxation spectra A and B exceeds a predetermined threshold value.

By following the above procedure, the state determination device 100 can determine the presence or absence of the battery abnormality from the single measurement of the secondary battery 210. Therefore, unlike PTL 1, the measurement of the secondary battery at the pre-degradation stage is unnecessary, and the state can be determined even for a battery the battery characteristics of which have already been degraded, such as a used battery.

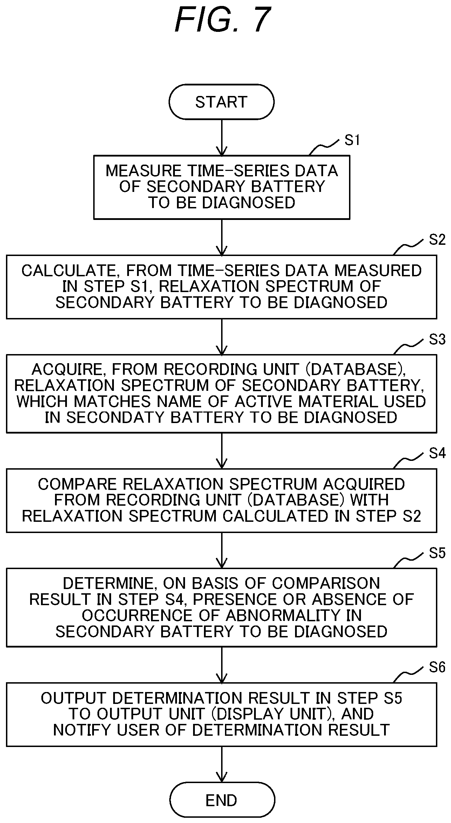

Fig. 7 illustrates a typical secondary battery diagnosis method using the state determination device 100 of the present embodiment.

When the state determination device 100 starts the process, first, in step S1, the measurement unit 11 measures time-series data of a secondary battery to be diagnosed.

Next, in step S2, the calculation unit 12 calculates, from the time-series data measured in step S1, a relaxation spectrum of the secondary battery to be diagnosed.

Next, in step S3, the comparison unit 14 acquires, from the recording unit 13 (database), a relaxation spectrum of a secondary battery, which matches the name of an active material used in the secondary battery to be diagnosed.

Subsequently, in step S4, the comparison unit 14 compares the relaxation spectrum acquired from the recording unit 13 (database) with the relaxation spectrum calculated in step S2.

Next, in step S5, the determination unit 15 determines, on the basis of the comparison result in step S4, the presence or absence of occurrence of an abnormality in the secondary battery to be diagnosed.

Finally, in step S6, the determination result in step S5 is output to the output unit 16 (display unit), a user is notified of the determination result, and the process ends.

The secondary battery 210 to which the present invention can be applied includes any form such as a secondary battery cell, a secondary battery module, a secondary battery pack, or a secondary battery system. Furthermore, the secondary battery 210 may be installed in an electric mobility device such as a ship, an aircraft, or a vehicle (battery-powered train, electric vehicle), may be installed in a stationary battery storage system, and the use of the secondary battery 210 may be changed during use. For example, the present invention can also be applied to a case where the secondary battery 210 used in the electric mobility device is reused as the stationary battery storage system.

The degraded secondary battery 210 was prepared, and the state determination device 100 verified if the presence or absence of the battery abnormality could be determined from the single measurement. For the verification, the recording unit 13 recorded the relaxation spectra of the secondary battery using graphite and lithium manganese oxide for the negative electrode and the positive electrode, respectively, as well as the relaxation spectra of the secondary battery using graphite and NMC for the negative electrode and the positive electrode, respectively. The capacities of these secondary batteries were 50Ah and 7Ah, respectively, which were about the same as the rated capacities described in the product specifications. Therefore, the relaxation spectra recorded in the recording unit 13 correspond to the relaxation spectra at the pre-degradation stage.

As the first embodiment, a 18650-type secondary battery (battery capacity: 2Ah) using graphite and NMC for the negative electrode and the positive electrode, respectively, was prepared. This secondary battery is different from the two secondary batteries recorded in the recording unit 13. Specifically, the secondary batteries recorded in the recording unit 13 both have rectangular external shapes, whereas of the secondary battery used in the first embodiment has a cylindrical external shape. Furthermore, the former has the battery capacity of 7Ah to 50Ah, whereas the latter has the battery capacity of approximately 2Ah.

The aforementioned 18650-type secondary battery 210 was allowed to stand in a 0°C environment, and was repeatedly subjected to full charge and complete discharge 100 times at a current value of 2A, thereby degrading the secondary battery capacity by approximately 20%. The degraded secondary battery 210 was connected to the state determination device 100, and the material information for each of the positive electrode and the negative electrode was input to the input unit 10. Furthermore, the secondary battery 210 was subjected to constant current charging from 3.8V to 3.9V at a current value of 4A, and then the charging mode was switched to constant voltage charging when the voltage reached 3.9V. Thereafter, constant voltage charging was continued for approximately one hour, and the time-series data of the voltage value and the current value during charging were acquired by the measurement unit 11.

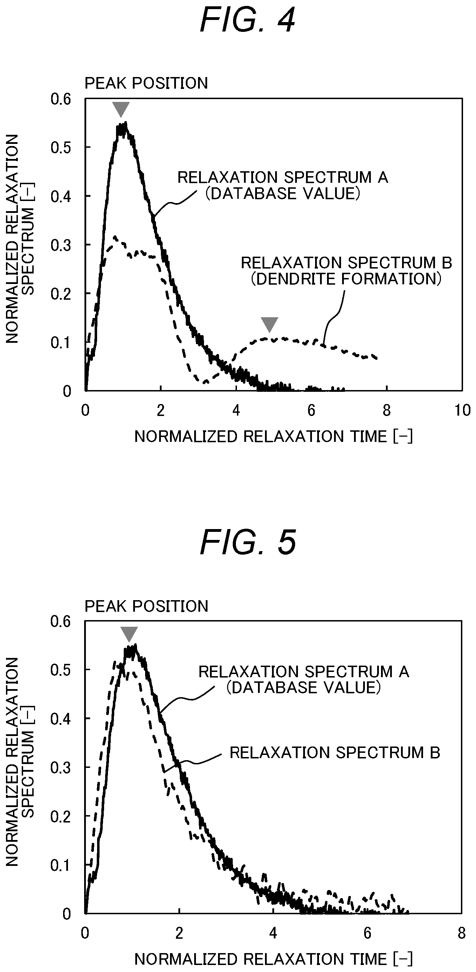

Fig. 4 illustrates the comparison result between the relaxation spectrum B of the secondary battery 210 obtained by the calculation unit 12 and the relaxation spectrum A acquired from the recording unit 13 in the comparison unit 14. Note that, for the comparison, the peak intensities and the relaxation times of the relaxation spectra A and B were normalized using Equation (3). The state in which the number of peaks in the relaxation spectrum B is greater than that in the relaxation spectrum A can be confirmed from Fig. 4.

On the basis of the above result, the determination unit 15 determined that the battery abnormality has occurred in the secondary battery 210 and the determination result was output to the output unit 16.

In order to verify the above determination result, the secondary battery 210 was dismantled and analyzed to investigate the presence or absence of the battery abnormality. In this case, the occurrence of lithium deposition was confirmed at the negative electrode of the secondary battery 210, and it was confirmed that the determination result was correct.

### Second Embodiment

A secondary battery state determination device and a secondary battery diagnosis method according to the second embodiment of the present invention will be described with reference to Fig. 5.

As the second embodiment, the secondary battery 210 of the first embodiment was allowed to stand in a 25°C environment, and was repeatedly charged and discharged 1000 times. All other test conditions and measurement conditions were the same as in the first embodiment.

Fig. 5 illustrates a comparison result of relaxation spectra A and B in a comparison unit 14 in the second embodiment. As illustrated in Fig. 5, the relaxation spectra A and B match well, and the determination unit 15 determined that no battery abnormality has occurred, and the determination result was output to the output unit 16.

In order to verify the above determination result, the secondary battery 210 was dismantled and analyzed to investigate the presence or absence of the battery abnormality. In this case, no signs of lithium deposition or current concentration were found in the secondary battery 210, and it was confirmed that the determination result was correct.

### Third Embodiment

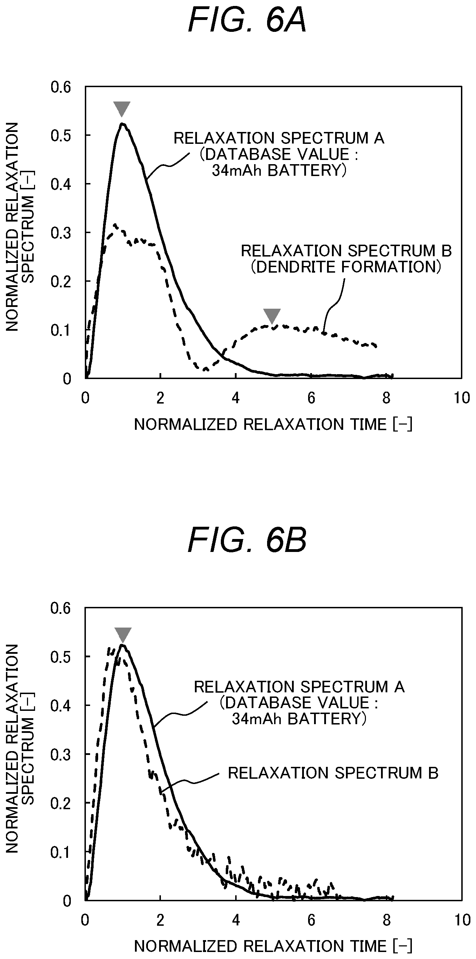

A secondary battery state determination device and a secondary battery diagnosis method according to the third embodiment of the present invention will be described with reference to Figs. 6A and 6B.

As the third embodiment, a relaxation spectrum recorded in a recording unit 13 was replaced with data measured in a different secondary battery. As the different secondary battery, a pouch-type secondary battery with a battery capacity of 34mAh was prepared. Furthermore, materials for a positive electrode and a negative electrode were lithium manganese oxide and graphite, and NMC and graphite, respectively. Using the data from the recording unit 13, the presence or absence of a battery abnormality was determined under the same conditions as in the first embodiment and the second embodiment.

Figs. 6A and 6B illustrate a comparison result of relaxation spectra A and B in the comparison unit 14 in the third embodiment. In the present embodiment, both of a case where the battery abnormality was present and a case where the battery abnormality was absent were confirmed.

In the case where the battery abnormality was present, as illustrated in Fig. 6A, a state can be confirmed in which the number of peaks in the relaxation spectrum B is greater than that in the relaxation spectrum A. On the basis of the result, the determination unit 15 determined that the battery abnormality has occurred in a secondary battery 210 and the determination result was output to the output unit 16.

On the other hand, in the case where the battery abnormality was absent, as illustrated in Fig. 6B, the relaxation spectra A and B match well, and the determination unit 15 determined that no battery abnormality has occurred, and the determination result was output to the output unit 16.

The comparison results of Figs. 6A and 6B are well consistent with the comparison results of the first embodiment (Fig. 4) and the second embodiment (Fig. 5), and it was confirmed that the presence or absence of the battery abnormality can correctly be determined also in the case of the third embodiment.

It should be noted that the present invention is not limited to the embodiments described above, and includes various modifications. For example, the embodiments described above have been described in detail to simply describe the present invention, and are not necessarily required to include all the described configurations. In addition, part of the configuration of one embodiment can be replaced with the configurations of other embodiments, and in addition, the configuration of one embodiment can also be added with the embodiments of other examples. In addition, part of the configuration of each of the embodiments can be subjected to addition, deletion, and replacement with respect to other configurations.

### Reference Signs List

10: input unit, 11: measurement unit, 12: calculation unit, 13: recording unit, 14: comparison unit, 15: determination unit, 16: output unit, 100: (secondary battery state) determination device, 200: battery system, 210: secondary battery

## Claims

1. A secondary battery state determination device comprising:
a database containing records of relaxation spectra measured for a plurality of secondary batteries, and names of active materials for positive electrodes and negative electrodes, which are used for electrodes of the plurality of secondary batteries;
a measurement unit for measuring time-series data of a secondary battery to be diagnosed;
a calculation unit for calculating, from the time-series data measured by the measurement unit, a relaxation spectrum of the secondary battery to be diagnosed;
a comparison unit for acquiring from the database a relaxation spectrum of a secondary battery, which matches a name of an active material used in the secondary battery to be diagnosed, and comparing the acquired relaxation spectrum with the relaxation spectrum calculated by the calculation unit; and
a determination unit for determining, on a basis of a comparison result in the comparison unit, presence or absence of occurrence of an abnormality in the secondary battery to be diagnosed.

2. The secondary battery state determination device according to claim 1, wherein
the relaxation spectra are each a relaxation time distribution in a biaxial coordinate system in which one axis represents a relaxation time and another axis represents a spectral intensity.

3. The secondary battery state determination device according to claim 1, wherein
the comparison unit compares shape information between the relaxation spectra, and
the shape information includes at least one of the number of peaks in the relaxation spectra, intensities of the peaks, positions of the peaks, areas of the peaks, full widths at half maximum of the peaks, and skewness of the peaks.

4. The secondary battery state determination device according to claim 3, wherein,
when comparing the shape information, the comparison unit normalizes areas of the relaxation spectra and a relaxation time for the comparison.

5. The secondary battery state determination device according to claim 1, wherein
the secondary battery to be diagnosed is a secondary battery that has been degraded due to being used in electric mobility applications including an electric vehicle and a battery-powered train.

6. The secondary battery state determination device according to claim 1, wherein
the secondary battery to be diagnosed is a secondary battery that has been degraded due to being used as a stationary power source.

7. The secondary battery state determination device according to claim 1, wherein
the database contains a record of a relaxation spectrum of a secondary battery in which lithium metal is used for at least one of a positive electrode and a negative electrode.

8. The secondary battery state determination device according to claim 1, wherein
the measurement unit measures time-series data of respective values including a DC current value and a value of at least either a DC voltage value or state of charge (SOC) during charging or discharging of the secondary battery to be diagnosed.

9. The secondary battery state determination device according to claim 1, wherein
the calculation unit calculates the relaxation spectrum of the secondary battery to be diagnosed, from time-series data during at least any one of periods which are during constant voltage charging, after charging, or after discharging of the secondary battery to be diagnosed.

10. A secondary battery diagnosis method comprising:
(a) a step of measuring time-series data of a secondary battery to be diagnosed;
(b) a step of calculating, from the time-series data measured in the step (a), a relaxation spectrum of the secondary battery to be diagnosed;
(c) a step of acquiring from a database a relaxation spectrum of a secondary battery, which matches a name of an active material used in the secondary battery to be diagnosed;
(d) a step of comparing the relaxation spectrum acquired in the step (c) with the relaxation spectrum calculated in the step (b); and
(e) a step of determining, on a basis of a comparison result in the step (d), presence or absence of occurrence of an abnormality in the secondary battery to be diagnosed.
